# EUROPEAN PATENT APPLICATION

(11) **EP 4 304 004 A1**
(43) Date of publication of application: **10.01.2024**
(21) Application number: 23182450.9
(22) Date of filing: 29.06.2023
(51) Int. Cl.: H01Q 1/00, H01P 1/20, H01R 24/48, H01R 13/66, H01R 13/533

(54) **AN EXPLOSION-PROOF FITTING FOR ANTENNAS, A CENTRAL ASSEMBLY FOR AN EXPLOSION-PROOF FITTING FOR ANTENNAS, AN EXPLOSION-PROOF BOX**

(30) Priority: 05.07.2022 IT 202200014221
(71) Applicant: SOLEXY S.R.L. UNINOMINALE, 25015 Desenzano del Garda, Brescia (IT)
(72) Inventor: SOLDO, Giovanni, I-25015 Desenzano del Garda, BRESCIA (IT)
(74) Representative: De Lorenzo, Danilo

(57) **Abstract**

An explosion-proof fitting (10) for connecting an antenna (12) in hazardous areas comprises:
- a housing (30) defining a cavity (36) between a first (32) and a second (34) end;
- an antenna attachment (48) at said first end (32) and a radio attachment (45) at said second end (34);
- a central assembly (6), accommodated in the cavity (36) .

The central assembly (6) comprises a capacitive blocking circuit (44) connected to the antenna attachment (48) and the radio attachment (45), and a shielding casing (5), about the capacitive blocking circuit (44), which remains at least partially spaced apart therefrom and from the housing (30). Between the shielding casing (5) and the housing (3) there is a sealing compound (50).

A central assembly (6) for an explosion-proof fitting (10), and an explosion-proof box (14) comprising an explosion-proof fitting (10) according to the present invention.

## Description

The present invention relates to a fitting for connecting an antenna. More specifically, it relates to an explosion-proof fitting for connecting an antenna to a casing for electrical circuits in an environment with the presence of a hazardous area, such as an explosion-proof box, a casing for safety areas, or an electrical conduit.

The installation of electrical equipment in environments with the presence of hazardous areas, e.g., areas at risk of explosion, requires the potential suppression of any hazardous electrical impulse intended to cross the electrical equipment, and the insertion of the electrical equipment into an explosion-proof box for withstanding the maximum force provided during an explosion.

In such an environment, the use is known of a capacitive blocking circuit inside the explosion-proof box (i.e., the safe area) for providing an inherent safety barrier or a complete burying of the antenna in a suitable sealing compound for hazardous areas is known. Disadvantageously, these methods are poorly flexible since they do not allow replacing the antenna quickly and easily. In fact, it is necessary to replace the whole antenna incorporated in the sealing compound (and any sealing fittings installed adjacent to the antenna). This is both costly and time-consuming.

Italian patents IT201900001079, IT201800021403 and Italian utility model IT201800005206 disclose a solution of an explosion-proof fitting for connecting an antenna to a casing for electrical circuits in an environment with the presence of a hazardous area. In such documents, the explosion-proof fitting consists of an outer housing delimiting an inner cavity, in which a capacitive blocking circuit is accommodated and being immersed in a sealing compound, which acts as a dielectric and protects the components from humidity.

Disadvantageously, such a type of explosion-proof fitting has several drawbacks. In fact, the sealing compound, generally resin, can cause an alteration of the passive filtering properties when it comes into contact with the capacitive blocking circuit.

Moreover, the explosion-proof fitting of the prior art is poorly suited to accommodate flexible printed circuits, since it requires complicated operations for fastening the circuit to the fitting during the assembly or complicated fastening contrivances inside the fitting.

Therefore, the need is felt for an explosion-proof fitting for connecting an antenna in an environment with the presence of a hazardous area, being capable of overcoming the aforesaid drawbacks of the prior art while being capable of maintaining the performance of a radio system to which the antenna is connected.

In particular, the need is felt to have a fitting adapted to generate a signal shielding by simultaneously maintaining the sealing properties provided by the sealing compound, while keeping the passive design filtering properties of the capacitive blocking circuit unaltered.

This is obtained by an explosion-proof fitting for antennas, a central assembly for an explosion-proof fitting for antennas, and an explosion-proof box according to the appended independent claims. The claims dependent thereon show preferred constructional variants, implying further advantageous aspects.

The subject of the present invention will now be described in detail, with the aid of the accompanying drawings, in which:
figure 1 is a diagrammatic view of an application of an explosion-proof fitting for antennas made according to the present invention, applied to an explosion-proof box in a hazardous area;
figure 2 is a section view of an explosion-proof fitting for antennas made according to an embodiment of the present invention;
figure 2a shows an enlarged detail of figure 2;
figure 3 is a section view of a central assembly for an explosion-proof fitting for antennas made according to an embodiment of the present invention;
figure 3a is a detailed view of the central assembly for a fitting for antennas in figure 3;
figure 4 is a cross-section view of the central assembly for a fitting for antennas in figure 3, cut with the plane A-A ;
figure 5 is a longitudinal section view of a central assembly for an explosion-proof fitting for antennas made according to a further embodiment of the present invention;
figures 6a and 6b show two detailed views of a second end of a central assembly for an explosion-proof fitting for antennas, each seen in a different embodiment of the present invention;
figures 7a, 7b and 7c show three detailed views of an antenna attachment of a central assembly for an explosion-proof fitting for antennas, in three different embodiments of the present invention;

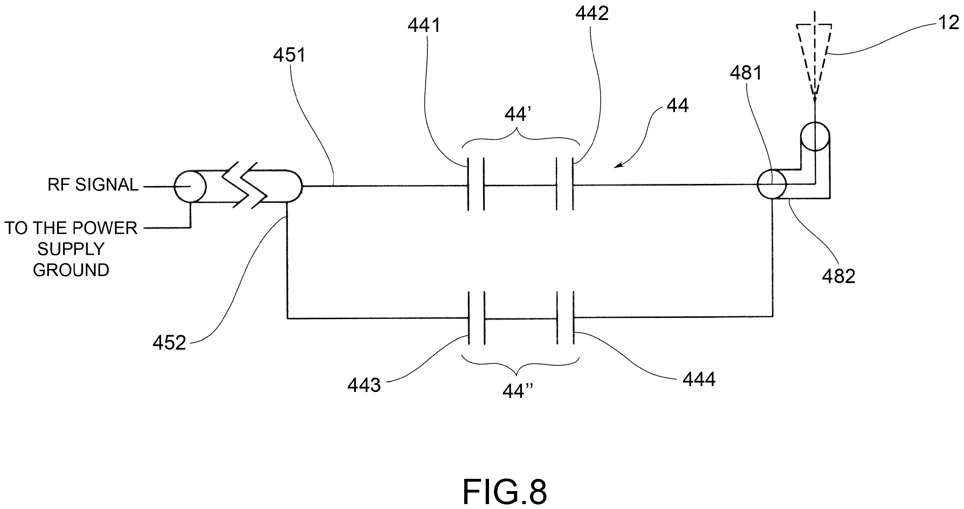

figure 8 shows a diagram of the electrical circuit of the explosion-proof fitting for antennas in an embodiment of the present invention.

With reference to the accompanying figures, an explosion-proof fitting 10 for antennas for connecting an antenna 12 in applications in hazardous areas, e.g., for the connection with an explosion-proof box 14 or an electrical conduit in a hazardous area, is indicated by reference numeral 10.

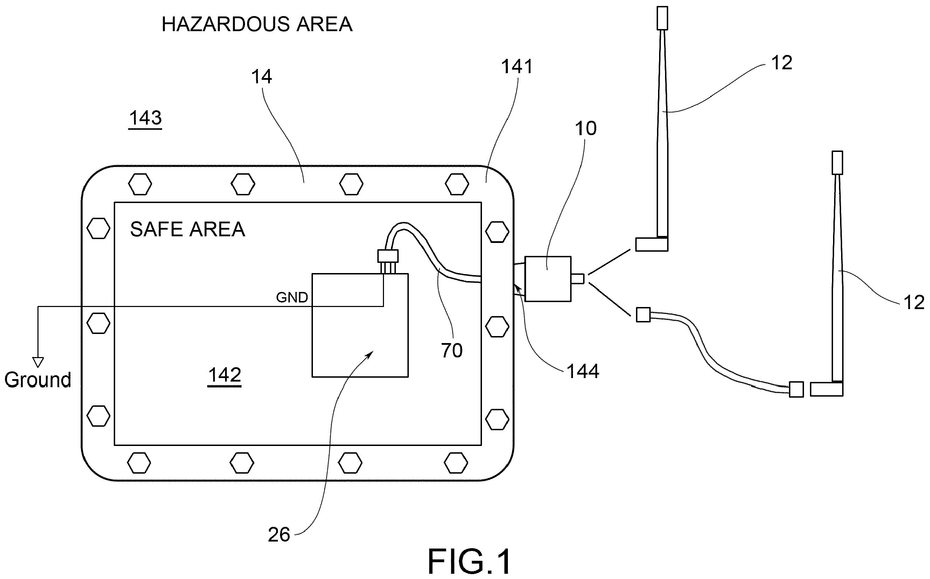

As discussed in greater detail below, figure 1 shows an example of an application of the explosion-proof fitting 10 for antennas in a hazardous area.

With reference to figure 1, the area inside the explosion-proof box 14 represents an electrically safe area, while the area outside the explosion-proof box 14 represents an environment with an electrically hazardous area classification. Therefore, the box 14 is an explosion-proof box 14 for use in an environment comprising electrically hazardous areas. As can be seen from figure 1, a standard antenna 12 can be directly mounted to the explosion-proof box 14 by means of the explosion-proof fitting 10.

The antenna 12 is preferably directly connected to a radio unit 26 inside the explosion-proof box 14 through the explosion-proof fitting 10, without needing to cross a separate capacitive blocking circuit arranged inside the hazardous area, which is generally used, instead, in the prior art for ensuring an inherently safe barrier. This is due to the fact that, as described below in greater detail, the explosion-proof fitting 10 includes a capacitive blocking circuit 44 providing an inherently safe barrier for suppressing an electrical impulse which can potentially travel through the fitting along the radio frequency signal conductor. The radio unit 26 receives power from an external power supply (not shown).

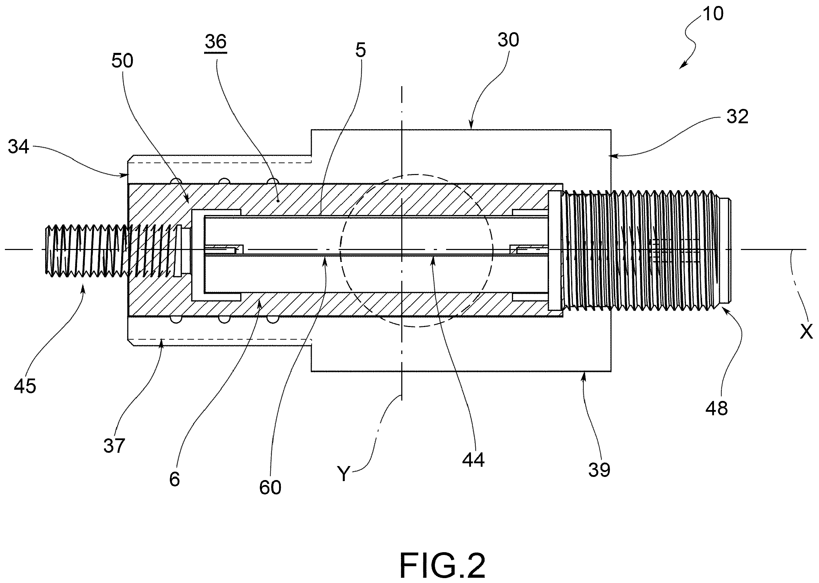

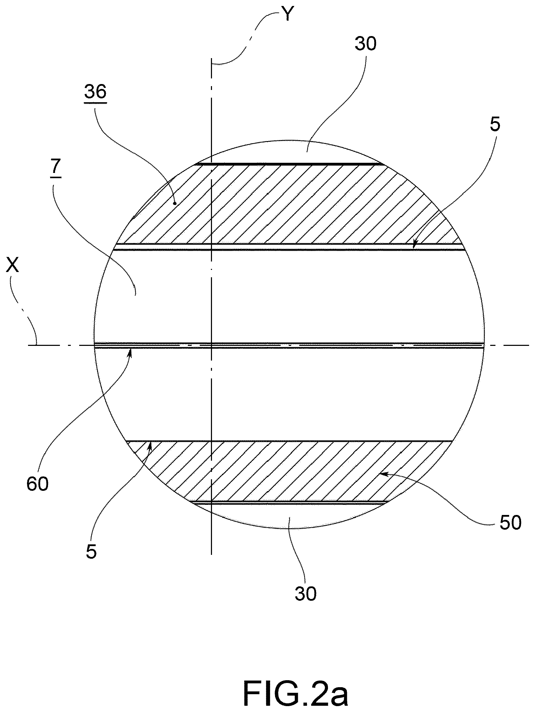

With reference to the example in figure 2, the explosion-proof fitting 10 for antennas comprises a housing 30, preferably a substantially cylindrical housing, which defines and extends between a first end 32 and a second 34 end. A cavity 36 is defined in the housing 30 between said first 32 and second 34 ends.

At said first end 32, the explosion-proof fitting 10 comprises an antenna attachment (or connector) 48.

The antenna attachment preferably comprises an antenna signal conductor 481 and an antenna return conductor 482.

At the second end 34, the explosion-proof fitting 10 comprises a radio attachment (or connector) 45.

The radio attachment 45 preferably comprises an electrical signal conductor 451 and an electrical return conductor 452.

Preferably, the radio attachment 45 is connected, preferably by means of said electrical return conductor 452, directly to the explosion-proof box 14, which is generally connected to ground, e.g., a power ground (as shown in figure 1, for example) and/or to the conductor of the power ground on the radio unit 26.

Moreover, the capacitive blocking circuit 44 is preferably directly connected to said electrical signal 451 and return 452 conductors, i.e., without any other intermediate electrical component, except for a simple conductor.

The electrical signal conductor 451 and the electrical return conductor 452 can be used to be directly connected to the radio unit 26. According to the present invention, the explosion-proof fitting 10 further comprises a central assembly 6, extending along a main extension axis X between the antenna attachment 48 and the radio attachment 45. Such a central assembly 6 is accommodated in the cavity 36 and comprises a capacitive blocking circuit 44 electrically connected to the antenna attachment 48 and the radio attachment 45.

Such a central assembly 6 further comprises a shielding casing 5, running about said capacitive blocking circuit 44 along said main extension axis X and remaining spaced apart from such a capacitive blocking circuit 44 at least along a transverse direction Y orthogonal to said main extension axis X, so that an interspace 7 between such a shielding casing 5 and such a capacitive blocking circuit 44 is formed.

Moreover, in particular, the central assembly 6 is accommodated in the cavity 36 so that the shielding casing 5, in turn, also remains spaced apart from the housing 30.

Preferably, the shielding casing 5 comprises a side wall running about and along the main extension axis X, having a plurality of sides, and such a shielding casing 5 remains spaced apart from the housing 30 about the whole side wall, i.e., along all sides of such a plurality of sides.

Inside the cavity 36, the explosion-proof fitting 10 comprises at least one sealing compound 50 which at least partially or completely encloses the central assembly 6. Preferably, the sealing compound completely fills the cavity 36.

In other words, the sealing compound 50 fills the space resulting between the shielding casing 5 and the housing 30 in the cavity 36.

Moreover, the central assembly 6 is preferably totally accommodated in the cavity 36.

In an embodiment of the invention, the interspace 7 is filled with a gas, a gas mixture, or air. Advantageously, the gas or gas mixture or air allows keeping the passive filtering features of the capacitive blocking circuit substantially unaltered within the limits of the design tolerances.

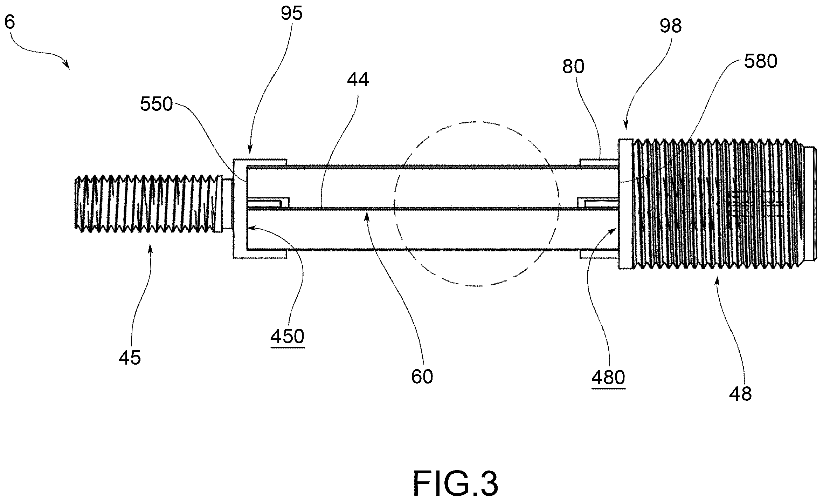

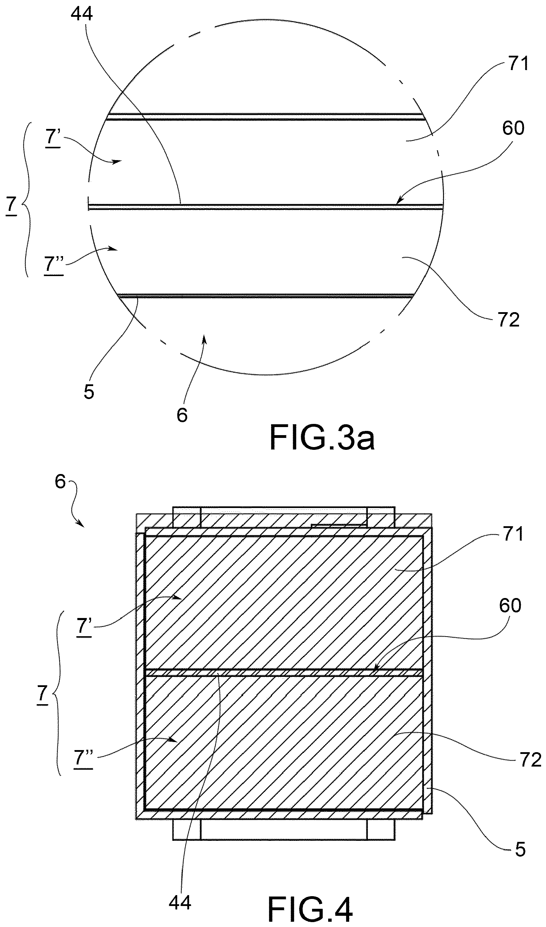

In an alternative embodiment of the invention, for example with reference to the accompanying figures 3a and 4, the explosion-proof fitting 10 comprises a filling material 71, 72 accommodated in the interspace, between the shielding casing 5 and the capacitive blocking circuit 44.

Preferably, such a filling material 71, 72 is a material suited to not alter at least the passive filtering features of the capacitive blocking circuit 44, so as to keep the passive filtering features within the design filtering tolerances.

Even more preferably, the filling material 71, 72 is polytetrafluoroethylene (PTFE, also known as Teflon).

Alternatively, the filling material 71, 72 consists of a material selected from the group comprising: Polyethylene, Polyamide, Polypropylene, Polystyrene, paper, Mica, Dioxide Silicon, Carbon Sulfide, PVC, Bi-Oriented Polyethylene Terephthalate (BoPET).

In a preferred embodiment, the filling material 71, 72 completely occupies the interspace 7.

In one embodiment, the filling material 71, 72 is liquid-based and adapted to solidify once inserted into the interspace 7.

In one embodiment of the invention, the capacitive blocking circuit 44 divides the interspace 7 into a first half-space 7' and a second half-space 7" arranged on the side opposite to the first half-space 7' with respect to the capacitive blocking circuit 44 and wherein the filling material 71, 72 consists of at least a first slat 71 arranged in the first half-space 7' and a second slat 72 arranged in the second half-space 7".

That is, in such an embodiment, the filling material 71, 72 is inserted directly into the interspace 7 in solid form, i.e., in the form of slats.

In a preferred embodiment, the shielding casing 5 is a bent metal sheet surrounding the capacitive blocking circuit 44.

Advantageously, such a metal sheet efficiently performs the function of shielding the circuit while ensuring the insulation of the capacitive circuit with respect to the sealing compound, which is always outside the shielding casing 5.

Preferably, the metal sheet is bent about the capacitive blocking circuit, giving the shielding casing 5 a prismatic shape, even more preferably a rectangular parallelepiped shape. Such a shape facilitates the steps of assembling and producing the explosion-proof fitting.

Even more preferably, the shielding casing 5 is made of a copper-nickel-zinc alloy, even more preferably is made of an alloy comprising a percentage of copper between 50% and 60%, a percentage of zinc between 15% and 30%, and a percentage of nickel from 10% to 30%. In other words, the shielding casing 5 is preferably made of German silver.

Advantageously, the German silver material has a good weldability and thus facilitates the production of the shielding casing 5, preferably in the form of metal sheet.

Moreover, preferably with reference to the embodiment in figure 4, the shielding casing 5 is at least partially in contact with a periphery of the capacitive blocking circuit 44.

In one embodiment of the present invention, the capacitive blocking circuit 44 comprises a first capacitive blocking circuit 44' connected between the electrical signal conductor 451 and the antenna signal conductor 481. The capacitive blocking circuit 44 further comprises a second capacitive blocking circuit 44" connected between the electrical return conductor 452 and the antenna return conductor 482.

Preferably, the first capacitive blocking circuit 44' comprises a first series of two capacitors 441, 442, and the second capacitive blocking circuit 44'' comprises a second series of two capacitors 443, 444. In such embodiments, the first series of capacitors 441, 442 and the second series of capacitors 443, 444 only consist of a series of two capacitors each, thus providing a more compact solution.

In one embodiment, each capacitor 441, 442, 443, 444 of first capacitive blocking circuit 44' and second capacitive blocking circuit 44" has a capacity value between 10 and 68 pF. This allows obtaining an optimized tuning to reduce the signal loss and minimizing the interacting capacity between the protection circuit on the power supply and the electrical return conductor 452 (return circuit).

Preferably, each capacitor of the first capacitive blocking circuit 44' and the second capacitive blocking circuit 44" has a minimum RMS voltage of 1500V.

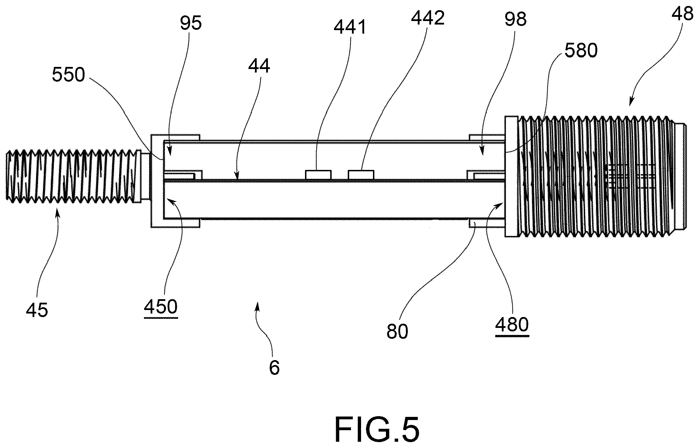

Moreover, each capacitor preferably has a maximum tolerance of 10%. In an embodiment of the present invention, for example shown in figure 5, the capacitive blocking circuit 44 is only a series of capacitors 441, 442.

Preferably, the series of capacitors only consists of a series of two capacitors 441, 442, thus providing a more compact solution.

In a particularly advantageous embodiment, with reference to the embodiment shown in figure 3, the explosion-proof fitting 10 comprises a circuit board 60, including the capacitive blocking circuit 44. Preferably, such a circuit board 60 is completely accommodated inside the shielding casing 5.

In a preferred embodiment, the circuit board 60 is a Printed Circuit Board, PCB.

Even more preferably, the circuit board 60 is an insulated flexible support, preferably a support made of polyamide material, for example Kapton, and comprises a series of capacitors 441, 442, preferably directly obtained in the flexible support.

This provides a compact solution, further reducing the volume of the explosion-proof fitting 10.

Preferably, the capacitive blocking circuit 44 is electrically connected to the antenna attachment 48 at an antenna connection end 98 and is electrically connected to the radio attachment 45 at a radio connection end 95.

Moreover, the capacitive blocking circuit 44 is preferably accommodated inside the shielding casing 5 in a suspended manner, and is held in place in the shielding casing 5 only by means of the connection to the antenna attachment 48 at the antenna connection end 98 and to the radio attachment 45 at the radio connection end 95.

Preferably, the antenna attachment 48 comprises a first connection seat 480 at the antenna connection end 98 of the capacitive blocking circuit 44, and the radio attachment 45 comprises a second connection seat 450 at the radio connection end 95 of the capacitive blocking circuit.

In particular, such first and second connection seats 480, 450 each accommodate a respective engagement portion 580, 550 of the shielding casing.

Even more preferably, the first and second connection seats 480, 450 comprise coupling pins 80 which are firmly fastened, e.g., welded, to the respective engagement portion 580, 550 of the shielding casing 5.

In other words, the shielding casing 5 is directly fastened at the ends thereof (or more generally, at the ends of the capacitive blocking circuit 44) to radio attachment 45 and antenna attachment 48.

Moreover, the shielding casing 5 is preferably accommodated inside the cavity 36 in a suspended manner and is kept connected to the housing 30 only at such engagement portions 580, 550 engaged in such first and second connection seats 480, 450.

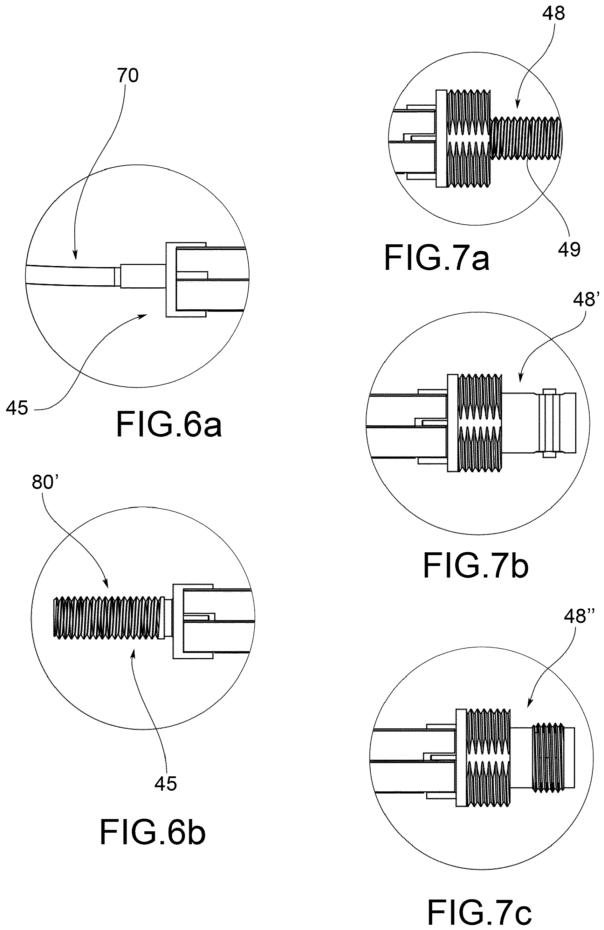

In an embodiment, for example shown in figure 6a, the radio attachment 45 comprises a coaxial cable 70. The coaxial cable 70 preferably comprises a central conductor and a shield.

In an embodiment, the central conductor of the coaxial cable 70 is connected to (or it is) the electrical signal conductor 451, while the shield of the coaxial cable 70 is connected to the electrical return conductor 452.

In a second embodiment, for example shown in figure 6b, the radio attachment 45 comprises a coaxial connector 80', protruding from the second end 34, which is adapted to receive a coaxial cable.

In a constructional variant, for example shown in figure 7a, the antenna attachment 48 has outer threads 49 and protrudes from the first end 32. For example, the antenna attachment can be an SMA or RP-SMA connector.

In an alternative constructional variant, for example shown in figure 7b, the antenna attachment 48 is a BNC-type connector 48'.

In a still alternative constructional variant, for example shown in figure 7c, the antenna attachment 48 is a TNC-type connector 48".

Preferably, the sealing compound 50 is a sealing compound for hazardous areas which acts as a dielectric, protects the central assembly 6 from humidity, potentially provides a traction release for the coaxial cable 70, and can withstand the force of an explosion.

Preferably, the sealing compound 50 is an epoxy compound, preferably an epoxy resin.

In an embodiment, the housing 30 further comprises an externally threaded portion 37, adjacent to said second end 34, and an integrally formed nut 39 adjacent to said first end 32. This configuration allows easy assembly on a casing or tube.

The housing 30 is preferably made of stainless steel 303 or 316 (UNS S30300 or UNS S31600).

It is apparent that a central assembly 6 for an explosion-proof fitting 10 for antennas is also a subject per se of the present invention.

According to the present invention, the central assembly 6 extends along a main extension axis X between an antenna attachment 48 and a radio attachment 45, and comprises:
- a capacitive blocking circuit 44 electrically connected to the antenna attachment 48 and the radio attachment 45;
- a shielding casing 5, running about the aforesaid capacitive blocking circuit 44 along such a main extension axis X and remaining spaced apart from such a capacitive blocking circuit 44 at least along a transverse direction Y orthogonal to the main extension axis X, so that an interspace 7 between said shielding casing 5 and said capacitive blocking circuit 44 is formed.

According to the present invention, the central assembly 6 is housable in a cavity 36 of an explosion-proof fitting 10 for antennas.

It is also apparent that all the constructional variants described in the present disclosure relating to detailed technical features of the explosion-proof fitting 10 of the present invention, with particular reference to the detailed technical features of the elements of a central assembly 6, also equally apply to the central assembly 6 per se, irrespective of whether such a central assembly 6 is accommodated in a cavity 36 of an explosion-proof fitting 10 or not.

As already mentioned, it is further apparent that the present invention is also directed to an explosion-proof box 14 for hazardous areas, comprising a containment wall 141 defining a safe area 142 on one side of said containment wall 141 and a hazardous area 143 on the other side of said containment wall 141. Moreover, such a containment wall 141 comprises or defines a threaded opening 144 through such a containment wall 141. Therefore, the explosion-proof box 14 comprises an explosion-proof fitting 10 for antennas as described in the preceding paragraphs and in particular coupled to the threaded opening 144, e.g., through the externally threaded portion 37 thereof.

Innovatively, the explosion-proof fitting for antennas according to the present invention allows overcoming all drawbacks of the explosion-proof fittings of the prior art. In particular, the explosion-proof fitting of the present invention is inherently protective and ensures the performance of the radio unit, minimizing the signal loss in the passage through the capacitive blocking circuit.

Innovatively, by virtue of the presence of the shielding casing, the explosion-proof fitting allows generating a signal shielding, while maintaining the sealing properties provided by the sealing compound.

Moreover, the explosion-proof fitting described generates little or even no alteration of the passive design filtering properties of the capacitive blocking circuit precisely due to the presence of the shielding casing interposed between the capacitive blocking circuit and the sealing compound, thus avoiding the direct contact thereof.

According to a further synergistic advantage, the shielding casing consisting of a bendable metal sheet provides the explosion-proof fitting with a good shielding performance and acts as a ground for the circuit itself.

Moreover, according to an even further advantage, the metal sheet facilitates the operations of assembling the explosion-proof fitting, and is easily assemblable with the radio and antenna attachments, by virtue of the convenient prismatic shape.

Moreover, the explosion-proof fitting for antennas of the present invention is advantageously compact and easy to construct.

Moreover, the central assembly for an explosion-proof fitting for antennas of the present invention advantageously lends itself to being integrated with the housings for known explosion-proof fittings for antennas, i.e., no conversion is required for such housings to be adapted to the central assembly of the present invention.

Moreover, according to a further advantageous aspect, the central assembly of the present invention also lends itself to being used in applications in non-hazardous areas, e.g., inside multi-channel connectors for non-hazardous areas.

It is apparent that those skilled in the art may make changes to the embodiments of the aforesaid explosion-proof fitting for antennas, central assembly for an explosion-proof fitting, and explosion-proof box, or may replace elements with others which are functionally equivalent in order to meet specific needs.

Such variants are also within the scope of protection as defined by the following claims. Moreover, each variation described as belonging to a possible embodiment can be implemented irrespective of the other variations described.

## Claims

1. An explosion-proof fitting (10) for antennas (12), for connecting an antenna (12) in hazardous areas, comprising:
- a housing (30) defining and extending between a first (32) and a second end (34) and defining a cavity (36) between said first (32) and second end (34);
- an antenna attachment (48) at said first end (32);
- a radio attachment (45) at said second end (34);
- a central assembly (6), extending along a main extension axis (X) between said antenna attachment (48) and said radio attachment (45), said central assembly (6) being accommodated in said cavity (36) and comprising:
- a capacitive blocking circuit (44) electrically connected to said antenna attachment (48) and said radio attachment (45);
- a shielding casing (5), running about said capacitive blocking circuit (44) along said main extension axis (X) and remaining spaced apart from said capacitive blocking circuit (44) at least along a transverse direction (Y), orthogonal to said main extension axis (X), so that an interspace (7) between said shielding casing (5) and said capacitive blocking circuit (44) is formed,
said central assembly (6) being accommodated in the cavity (36) so that the shielding casing (5) remains spaced apart from the housing (30),
and wherein the explosion-proof fitting (1) comprises a sealing compound (50) in the cavity (36), arranged between the shielding casing (5) and the housing (3), said sealing compound (50) at least partially or completely enclosing the central assembly (6).

2. Explosion-proof fitting (10) for antennas according to claim 1, wherein the central assembly (6) is completely accommodated in the cavity (36).

3. Explosion-proof fitting (10) for antennas according to claim 1 or 2, wherein the interspace (7) is filled with a gas, a gas mixture, or air.

4. Explosion-proof fitting (10) for antennas according to claim 1 or 2, comprising a filling material (71, 72) accommodated in said interspace (7) between said shielding casing (5) and said capacitive blocking circuit (44) .

5. Explosion-proof fitting (10) for antennas according to the preceding claim, wherein the filling material (71, 72) is polytetrafluoroethylene (Teflon).

6. Explosion-proof fitting (10) for antennas according to claim 4, wherein the filling material (71, 72) consists of a material selected from the group comprising: Polyethylene, Polyamide, Polypropylene, Polystyrene, paper, Mica, Dioxide Silicon, Carbon Sulfide, PVC, Bi-Oriented Polyethylene Terephthalate (BoPET).

7. Explosion-proof fitting (10) for antennas according to any one of claims 4 to 6, wherein the filling material (71, 72) totally occupies said interspace (7).

8. Explosion-proof fitting (10) for antennas according to any one of claims 4 to 7, wherein the capacitive blocking circuit (44) divides the interspace (7) into a first half-space (7') and a second half-space (7") arranged on the side opposite to the first half-space (7') with respect to the capacitive blocking circuit (44) and wherein the filling material (71, 72) consists of at least a first slat (71) arranged in the first half-space (7') and a second slat (72) arranged in the second half-space (7").

9. Explosion-proof fitting (10) for antennas according to any one of the preceding claims, wherein the shielding casing (5) is a bent metal sheet surrounding the capacitive blocking circuit (44).

10. Explosion-proof fitting (10) for antennas according to any one of the preceding claims, comprising a circuit board (60) which comprises the capacitive blocking circuit (44), wherein said circuit board (60) is completely contained in said shielding casing (5).

11. Explosion-proof fitting (10) for antennas according to the preceding claim, wherein the circuit board (60) is an insulated flexible support, preferably made of polyamide material, for example it is a Kapton support, and comprises a series of capacitors (441, 442) directly obtained in the flexible support.

12. Explosion-proof fitting (10) for antennas according to any one of the preceding claims, wherein said sealing compound (50) is a sealing compound for hazardous areas.

13. Explosion-proof fitting (10) for antennas according to any one of the preceding claims, wherein the capacitive blocking circuit (44) is electrically connected to said antenna attachment (48) at an antenna connection end (98) and is connected to said radio attachment (45) at a radio connection end (95),
and wherein the antenna attachment (48) comprises a first connection seat (480) at the antenna connection end (98), and wherein the radio attachment (45) comprises a second connection seat (450) at the radio connection end (95), said first and second connection seats (480, 450) each accommodating an engagement portion (580, 550) of the shielding casing (5).

14. Explosion-proof fitting (10) for antennas according to the preceding claim, wherein the first and second connection seats (480, 450) comprise coupling pins (80) which are firmly fastened, for example welded, to said engagement portion (580, 550) of the shielding casing (5) .

15. A central assembly (6) for an explosion-proof fitting (10) for antennas, extending along a main extension axis (X) between an antenna attachment (48) and a radio attachment (45), said central assembly (6) comprising:
- a capacitive blocking circuit (44) electrically connected to said antenna attachment (48) and said radio attachment (45);
- a shielding casing (5), running about said capacitive blocking circuit (44) along said main extension axis (X) and remaining spaced apart from said capacitive blocking circuit (44) at least along a transverse direction (Y), orthogonal to said main extension axis (X), so that an interspace (7) between said shielding casing (5) and said capacitive blocking circuit (44) is formed,
said central assembly (6) being accommodable in a cavity (36) of an explosion-proof fitting (10) for antennas.

16. An explosion-proof box (14) for hazardous areas, comprising:
a containment wall (141) defining a safe area (142) on one side of said containment wall (141) and a hazardous area (143) on the other side of said containment wall (141), said containment wall (141) further defining a threaded opening (144) through said containment wall (141); and
an explosion-proof fitting (10) for antennas according to any one of the claims from 1 to 14.
